Europäisches Patentamt

European Patent Office

Office européen des brevets

(11) Numéro de publication: **0 243 255 B1**

# FASCICULE DE BREVET EUROPEEN

(45) Date de publication de fascicule du brevet:
24.07.91

(21) Numéro de dépôt: 87400892.3

(22) Date de dépôt: 17.04.87

(51) Int. Cl.⁵: **G11C 27/02, H04N 5/217**

(54) Circuit d'échantillonnage et maintien de signal à faible résidu d'échantillonnage et utilisation de ce circuit au double échantillonnage corrélé de signaux.

(30) Priorité: **22.04.86 FR 8605804**

(43) Date de publication de la demande:
**28.10.87 Bulletin 87/44**

(45) Mention de la délivrance du brevet:
**24.07.91 Bulletin 91/30**

(84) Etats contractants désignés:
**DE FR GB IT**

(56) Documents cités:
**FR-A- 2 361 773**
**US-A- 3 965 368**
**US-A- 4 283 742**

**ELECTRONIC ENGINEERING, vol. 48, no. 577, mars 1976, pages 47-49, Londres, GB; R.C. TOZER: "Sample and hold gates using field effect transistors"**

**FUNKSCHAU, no. 4, février 1982, pages 70-72, Munich, DE; W. STRÖSSENREUTHER: "Nf-Störspannung wirksam unterdrückt"**

(73) Titulaire: **THOMSON-CSF**
**51, Esplanade du Général de Gaulle**
**F-92800 Puteaux(FR)**

(72) Inventeur: **Eouzan, Jean-Yves**
**THOMSON-CSF SCPI 19, avenue de Messine**
**F-75008 Paris(FR)**
Inventeur: **Heurtaux, Jean-Claude**
**THOMSON-CSF SCPI 19, avenue de Messine**
**F-75008 Paris(FR)**

(74) Mandataire: **Lincot, Georges et al**
**THOMSON-CSF SCPI**
**F-92045 PARIS LA DEFENSE CEDEX 67(FR)**

## Description

La présente invention concerne un circuit d'échantillonnage et maintien à faible résidu d'échantillonnage et son utilisation au double échantillonnage corrélé de signaux vidéo fournis par des dispositifs à transfert de charge.

Il est connu de la façon décrite dans le brevet US 4 283 742 - dont l'art antérieur est tenu compte dans le préambule de la revendication 1 - de réaliser des circuits d'échantillonnage et maintien à l'aide d'une cellule de mémorisation d'échantillons de signaux fournis par un interrupteur de courant et un condensateur. Dans ces réalisations l'interrupteur de courant est souvent constitué par un transistor à effet de champ relié par une électrode de source ou de drain au condensateur, l'autre électrode respectivement drain ou source recevant le signal à échantillonner. L'état ouvert ou fermé de l'interrupteur de courant ainsi constitué est commandé par des impulsions d'échantillonnage appliquées sur l'électrode de grille du transistor à effet de champ. A chaque impulsion d'échantillonnage, un courant circule dans le transistor à effet de champ qui charge le condensateur pendant toute la durée où l'impulsion de commande est appliquée.

Cependant, les capacités interélectrodes des transistors à effet de champ sont la cause de tensions parasites résiduelles à la fréquence des signaux de commande qui se superposent au signal échantillonné à la sortie du circuit d'échantillonnage et provoque en télévision une variation du niveau de noir du signal vidéo obtenu à la sortie des matrices à transfert de charge équipant les caméras de télévision.

Le but de l'invention est de pallier les inconvénients précités.

A cet effet, l'invention a pour objet, un circuit d'échantillonnage et maintien, pour le double échantillonnage corrélé d'un signal, le signal étant fourni par un étage convertisseur charge/tension d'un dispositif à transfert de charge, ce circuit d'échantillonnage comprenant un premier circuit échantillonneur bloqueur, un deuxième circuit échantillonneur bloqueur identique au premier circuit échantillonneur et un troisième circuit échantillonneur bloqueur, le premier et le deuxième circuit échantillonneurs bloqueurs étant respectivement couplés par leurs sorties à une première et une deuxième entrée d'un circuit soustracteur, le signal fourni par le dispositif à transfert de charge est appliqué d'une part, directement aux entrées respectives des premier et troisième circuits échantillonneurs bloqueurs et d'autre part, à l'entrée du deuxième circuit échantillonneur bloqueur au travers du troisième circuit échantillonneur bloqueur, caractérisé en ce que le signal est un signal vidéo partagé en trois intervalles de temps juxtaposés pour transmettre respectivement un niveau de noir, un signal de luminance et une impulsion d'initialisation, et que le premier et le deuxième circuit échantillonneur bloqueur sont commandés simultanément pendant les intervalles de temps où le signal de luminance apparaît, le troisième circuit échantillonneur bloqueur étant commandé pendant les intervalles de temps où le niveau de noir est présent, de façon à aligner correctement le niveau de noir pour chaque échantillon du signal de luminance.

L'invention a également pour objet l'utilisation du circuit d'échantillonnage et maintien au double échantillonnage corrélé de signaux fournis par des dispositifs à transfert de charge.

Outre le fait qu'il permet de fixer à un niveau stable le niveau de noir du signal vidéo, le circuit d'échantillonnage et maintien de signal, selon l'invention, a principalement pour avantage qu'il permet l'échantillonnage de signaux vidéo sur une grande dynamique, de présenter des temps d'acquisition et d'établissement très faibles, avec une durée de rétention de l'information très grande en raison des courants de fuite très faibles des premier et deuxième circuits d'échantillonnage.

Les caractéristiques et avantages de l'invention apparaîtront au cours de la description qui suit faite en regard des dessins annexés qui représentent:

- la figure 1 le schéma de réalisation du circuit d'échantillonnage et maintien selon l'invention;
- la figure 2 un schéma de réalisation d'un circuit échantillonneur-bloqueur;
- la figure 3 un graphe des temps illustrant le fonctionnement d'un circuit échantillonneur conforme à la figure 2;
- la figure 4 un schéma de principe pour illustrer le fonctionnement d'un étage de conversion charge-tension d'un dispositif à transfert de charge;
- la figure 5 un chronogramme pour illustrer le fonctionnement du dispositif de la figure 4 lorsque celui-ci est sollicité par des signaux de commande de dispositifs à transfert de charges;
- la figure 6 une utilisation du dispositif selon l'invention au traitement des signaux fournis par des étages de conversion charge-tension du type représenté à la figure 4;
- la figure 7 un chronogramme illustrant le fonctionnement du dispositif représenté à la figure 6.

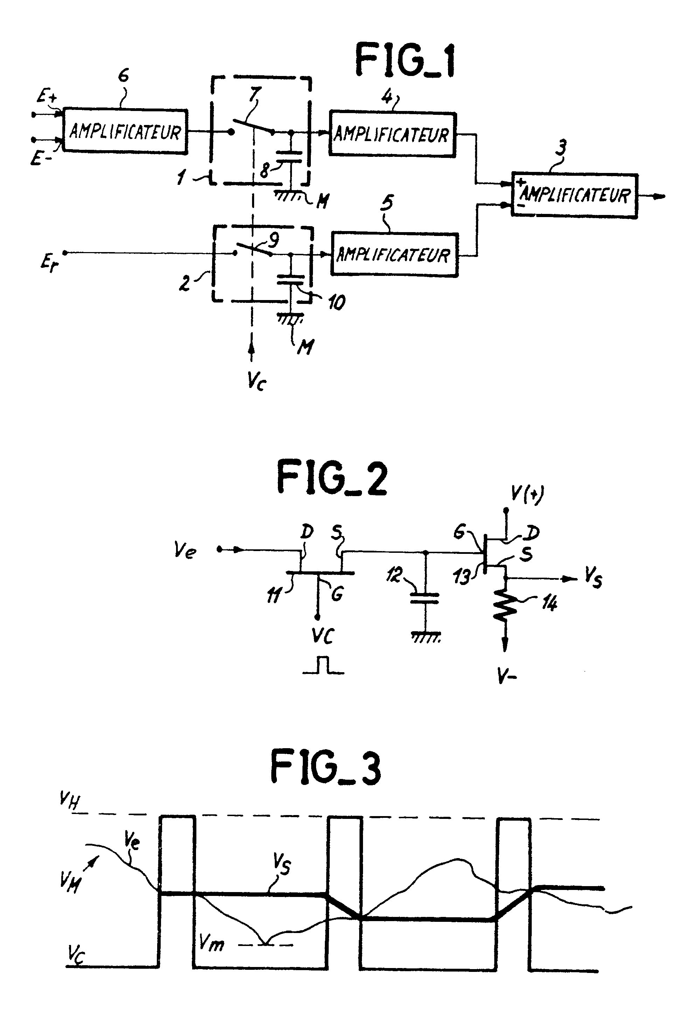

Le circuit d'échantillonnage et de maintien qui est représenté à la figure 1, comprend un premier circuit échantillonneur-bloqueur 1 et un deuxième circuit échantillonneur-bloqueur 2, représentés respectivement à l'intérieur de rectangles en pointillés, reliés tous deux à un amplificateur différentiel 3 au travers respectivement d'amplificateurs-adaptateurs d'impédance 4 et 5. Le signal à échantillonner est appliqué à l'entrée du circuit échantillonneur-bloqueur 1 au travers d'un amplificateur opérationnel 6, l'application de ce signal pouvant se faire indifféremment sur les entrées E + ou E - de l'amplificateur 6. Le circuit échantillonneur-bloqueur 1 est constitué de façon connue par un interrupteur de courant 7 placé en série entre la sortie de l'amplificateur 6 et l'entrée de l'amplificateur-adaptateur d'impédance 4 et par un condensateur 8 placé entre l'entrée de l'amplificateur-adaptateur d'impédance 4 et le circuit de masse M du circuit. De façon similaire le circuit échantillonneur-bloqueur 2 est constitué par un interrupteur de courant 9 et par un condensateur 10 placé entre l'entrée de l'amplificateur-adaptateur d'impédance 5 et le circuit de masse de l'ensemble du dispositif. L'interrupteur de courant 9 a pour fonction d'appliquer une tension continue $E_r$ à l'entrée de l'amplificateur-adaptateur d'impédance 5 et de charger, durant tout le temps où cette tension est appliquée, le condensateur 10. Les interrupteurs de courant 7 et 9 sont commandés simultanément par un signal de commande $V_c$.

Un mode de réalisation des circuits échantillonneurs-bloqueurs est représenté à la figure 2. L'échantillonneur-bloqueur représenté est constitué par un transistor à effet de champ 11 qui joue le rôle des interrupteurs de courant 7 et 9, d'un condensateur 12 similaire aux condensateurs 8 et 10 de la figure 1, couplé à l'électrode de grille d'un transistor à effet de champ 13 monté en adaptateur d'impédance au moyen d'une résistance 14 placée dans le circuit de l'électrode de source du transistor à effet de champ 13. Sur la figure 2, le signal $V_e$ à échantillonner est appliqué sur l'électrode de drain du transistor 11 et est appliqué aux bornes du condensateur 12 lorsqu'une impulsion de commande positive $V_c$ est appliquée sur l'électrode de grille du transistor 11, pour réaliser l'échantillonnage. En supposant que dans l'exemple représenté le transistor à effet de champ 11 est un transistor de type N à enrichissement les potentiels sur ces électrodes sont définis de la manière qui est représentée à la figure 3 qui représente juxtaposées sur un même graphe les tensions de commande $V_c$ du transistor de champ 11, la tension à échantillonner $V_e$ appliquée sur le drain du transistor 11 et la tension $V_s$ obtenue sur l'électrode de source du transistor à effet de champ 13. Il apparaît sur la figure 3 que l'amplitude maximale de la tension de commande de l'électrode de grille du transistor à effet de champ 11 doit avoir une amplitude $V_H$ supérieure de quelques volts à la tension maximale $V_M$ de la tension $V_e$ pouvant être échantillonnée et que le niveau bas de cette tension de commande doit être tel que le transistor à effet de champ 11 reste bloqué malgré l'évolution de la tension appliquée sur l'électrode de drain vers une valeur minimale $V_m$. L'instant d'échantillonnage est déterminé pendant toute la durée pendant laquelle le signal de commande $V_c$ présente son amplitude maximale $V_H$ et durant cet instant, la tension correspondante du signal à échantillonner $V_e$ est appliquée aux bornes du condensateur 12 pour rester mémorisée aux bornes de ce condensateur jusqu'à l'apparition de l'impulsion de commande suivante. La tension développée aux bornes du condensateur 12 est lue au travers du transistor à effet de champ 13 dont la haute valeur d'impédance d'entrée limite la décharge du condensateur 12. Pour permettre un bon fonctionnement du dispositif selon l'invention, il est impératif que les deux circuits échantillonneurs-bloqueurs 1 et 2 soient réalisés de façon strictement identiques, pour que l'amplificateur différentiel 3 puisse éliminer les signaux parasites d'échantillonnage dûs aux imperfections de l'interrupteur de courant 7, puisque dans cette hypothèse, les mêmes signaux parasites sont nécessairement engendrés par l'interrupteur de courant 9. De la sorte, les signaux parasites engendrés par chacun des circuits échantillonneurs-bloqueurs 1 et 2 sont soustraits les uns des autres par l'amplificateur différentiel 3 et le signal échantillonné fourni par la sortie du circuit amplificateur différentiel 3 est ainsi débarrassé des signaux parasites transmis par les capacités parasites inter-électrodes des interrupteurs de courant 11.

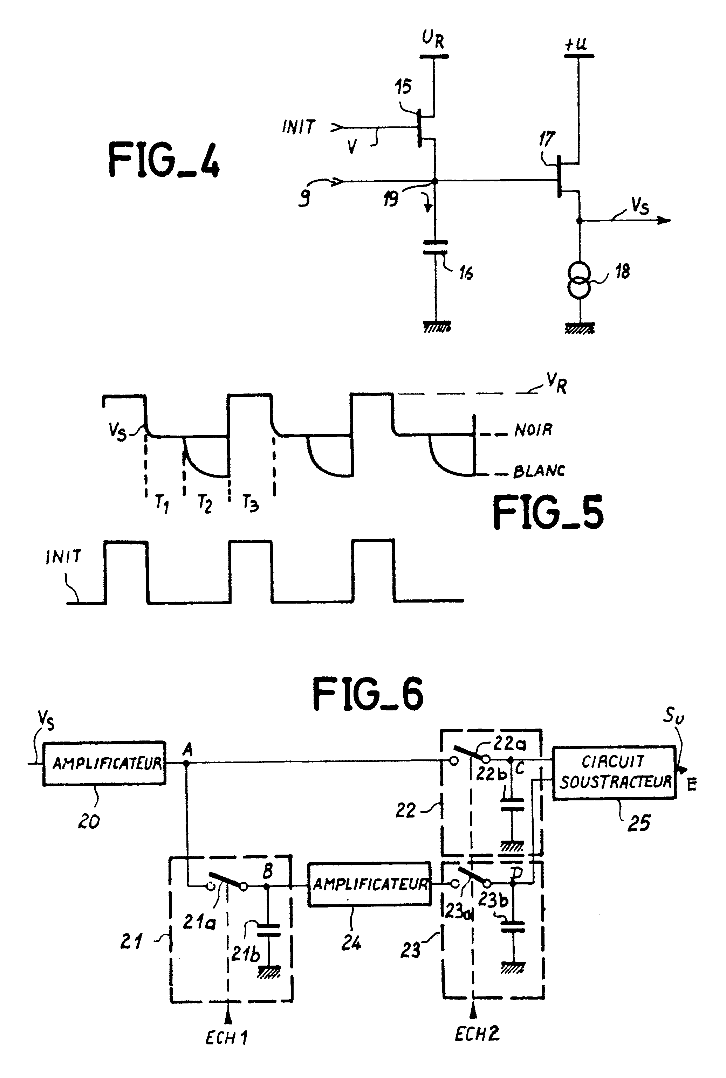

Le circuit d'échantillonnage et de maintien selon l'invention qui vient d'être décrit à l'aide des figures 1, 2 et 3 peut être appliqué avantageusement à la réalisation de circuits à double échantillonnage et maintien corrélé utilisables pour le traitement des signaux fournis par les dispositifs à transfert de charge et notamment pour le traitement des signaux vidéo fournis par les matrices à transfert de charges des caméras de télévision. Une illustration de ce problème est fournie par les figures 4 et 5 qui représentent, figure 4 le schéma de principe de l'étage de conversion "charge-tension" qui constitue généralement un dispositif à transfert de charge et figure 5 un chronogramme pour illustrer le fonctionnement du dispositif de la figure 4 lorsque celui-ci transmet un signal. L'étage de conversion charge-tension électrique qui est représenté à la figure 4 comprend, un transistor à effet de champ 15, relié en série à un condensateur 16 entre un potentiel + $U_R$ de référence et un point de masse M. Le point commun entre la source ou le drain du transistor 15 avec le condensateur 16 est relié à la grille de commande d'un transistor à effet de champ 17 qui est alimenté sur son drain ou sur sa source par une source de courant 18. Dans le dispositif à transfert de charge qui est ainsi représenté, des charges électriques q à transférer sont appliquées au point commun 19 entre le transistor 15 et le condensateur 16. Celles-ci développent une tension aux bornes du condensateur 16. Entre deux injections de charge, le condensateur 16 est réinitialisé avec une tension de référence $U_R$ par la mise en conduction du transistor 15 qui reçoit sur sa grille un signal d'initialisation INIT. Le signal développé aux bornes du condensateur 16 est recopié par le transistor 17 qui restitue un signal $V_s$ aux bornes de la source de courant 18. Le transistor 17 permet ainsi la lecture à haute impédance du signal qui est ainsi développé aux bornes du condensateur 16.

En retournant au chronogramme représenté à la figure 5, le signal $V_s$ apparaît composé de trois parties qui apparaissent régulièrement au cours d'intervalles de temps $T_1$, $T_2$ et $T_3$ juxtaposés dans cet ordre sur la figure 5.

La partie non utile du signal $V_s$, référençant par exemple le niveau du noir d'un signal vidéo apparaît durant l'intervalle de temps $T_1$. La partie du signal utile apparaît au cours de l'intervalle de temps $T_2$. Enfin la partie du signal qui apparaît durant l'intervalle de temps $T_3$ est provoquée par l'impulsion d'initialisation qui est appliquée sur la grille du transistor 15. Pendant l'intervalle de temps $T_2$ l'amplitude du signal $V_s$ peut varier entre un niveau de référence, par exemple, celui du noir si le signal $V_s$ est un signal vidéo, lorsqu'aucune charge n'est injectée dans le condensateur 16 et jusqu'à un niveau maximal correspondant à un niveau de saturation lorsque les charges injectées dans le condensateur 16 développent une tension maximale négative. La partie apparaissant durant l'intervalle de temps $T_3$ devrait théoriquement avoir le même niveau que la partie apparaissant durant l'intervalle de temps $T_1$ car elle correspond à la phase d'initialisation mais on constate qu'une impulsion parasite est ajoutée au signal pendant la durée de cette initialisation, cette impulsion étant due au couplage capacitif existant entre le condensateur 16 et l'électrode de commande du transistor 15.

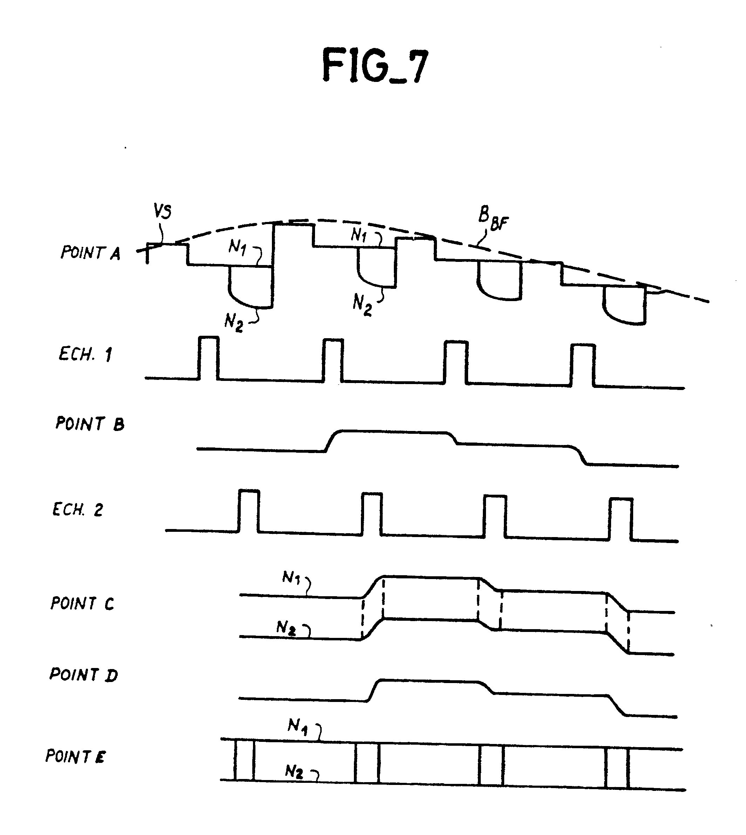

Cette difficulté est surmontée grâce à l'utilisation du circuit selon l'invention pour réaliser un circuit de multiplexage du type de celui qui est représenté à la figure 6. Le dispositif représenté à la figure 6 comprend un premier amplificateur 20, des premier, deuxième et troisième circuits échantillonneurs-bloqueurs portant respectivement les références 21, 22 et 23, un amplificateur 24 et un circuit soustracteur 25. L'amplificateur 20 reçoit sur son entrée le signal $V_s$ de la figure 5 fourni par le dispositif à transfert de charges, décrit précédemment à l'aide de la figure 4, à la sortie duquel il est connecté. La sortie (point A) du circuit amplificateur 20 est reliée d'une part, à l'entrée du premier circuit échantillonneur-bloqueur 21 et d'autre part, à l'entrée du deuxième circuit échantillonneur-bloqueur 22. La sortie (point B) du premier circuit échantillonneur-bloqueur 21 est reliée à l'entrée du troisième circuit échantillonneur-bloqueur 23 par l'intermédiaire du circuit amplificateur 24. Les sorties des deuxième (point C) et troisième (point D) échantillonneurs-bloqueurs 22 et 23 sont reliées respectivement aux entrées marquées "+" et "-" du circuit soustracteur 25. Chacun des circuits échantillonneurs-bloqueurs 21, 22, 23 est constitué de façon connue par des interrupteurs de courant à transistor à effet de champ ou équivalent notés respectivement 21a, 22a, 23a et par des condensateurs référencés respectivement 21b, 22b, et 23b. Le condensateur 22b est branché entre l'entrée marquée "+" du circuit soustracteur 25 et la ligne de masse M. Le condensateur 21b est relié entre l'entrée du circuit amplificateur 24 et la ligne de masse M. Le condensateur 23b est relié entre l'entrée marquée "-" du soustracteur 25 et la ligne de masse M. Le circuit interrupteur 22a réalise la connexion de la sortie du circuit amplificateur 20 avec d'une part, l'entrée marquée "+" du circuit soustracteur 25 et d'autre part, l'extrémité correspondante du condensateur 22b. Le circuit interrupteur 21a réalise la connexion entre la sortie du circuit amplificateur 20 avec d'une part, l'entrée du circuit amplificateur 24 et l'extrémité correspondante du condensateur 21b. Enfin l'interrupteur de courant 23a réalise la connexion entre la sortie du circuit amplificateur 24 avec d'une part, l'entrée "-" du circuit soustracteur 25 et d'autre part, l'extrémité correspondante du condensateur 23b.

L'interrupteur de courant 21a est commandé par un signal d'échantillonnage ECH 1 et les interrupteurs de courant 22a et 23a sont commandés simultanément par un signal d'échantillonnage ECH 2 dont les positions relatives dans le temps par rapport au signal d'entrée $V_s$ sont représentées à la figure 7. Le signal $V_s$ représenté à la figure 7 a la forme du signal de la figure 5 à la différence toutefois qu'il lui est rajouté une composante de bruit $B_{BF}$ basse fréquence dont l'enveloppe est représentée en pointillés. Le signal qui est représenté en-dessous du signal $V_s$ est le signal d'échantillonnage ECH 1 qui commande la fermeture de l'interrupteur de courant 21a à chaque apparition du niveau de noir du signal $V_s$. Le signal échantillonné représentant les niveaux de noir du signal $V_s$ qui est appliqué sur l'entrée de l'amplificateur 24 est représenté à la ligne suivante sous la forme de paliers représentant les niveaux successifs de noir du signal $V_s$. Le signal ECH 2, qui est représenté à la ligne suivante et qui commande la fermeture des interrupteurs de courant 22a et 23a apparaît simultanément aux instants d'apparition de l'information utile du signal $V_s$ et les échantillons

retenus qui sont mémorisés dans le condensateur 22b branché à l'entrée marquée "+" du circuit soustracteur 25 sont représentés à la ligne suivante sous la forme de deux signaux juxtaposés correspondant, dans l'exemple de représentation du signal $V_s$,à deux niveaux, minimal , $N_1$ , et maximal, $N_2$, $N_1$ correspond par exemple pour un signal vidéo à un niveau de noir et $N_2$ au niveau de saturation. La ligne suivante représente le signal qui est appliqué à l'entrée marquée "-" du soustracteur 25 et qui correspond au transfert des niveaux du signal, mémorisé dans le condensateur 21b, dans le condensateur 23b aux instants d'échantillonnage ECH 2. Enfin sur la dernière ligne sont représentés les signaux correspondant aux niveaux $N_1$ et $N_2$ du signal $V_s$ représenté sur la première ligne et qui apparaissent en sortie du circuit soustracteur 25 (point E).

Si l'on désigne par $B_{BF}$ la composante de bruit basse fréquence, par PAR 1 le signal parasite fourni par le circuit échantillonneur-bloqueur 21, par PAR 2 le signal parasite fourni respectivement par chacun des circuits échantillonneurs-bloqueurs 22, 23, et par $S_u$ le signal utile du signal $V_s$, le fonctionnement du circuit de la figure 6 peut être explicité à l'aide de ces notations de la façon suivante. Le signal qui est mémorisé dans le condensateur 21b par le circuit échantillonneur-bloqueur 21 contient l'information bruit basse fréquence $B_{BF}$ auquel s'ajoute le signal parasite PAR 1. Le signal qui est mémorisé dans le condensateur 22b par le circuit échantillonneur-bloqueur 22 contient l'information de signal utile $S_u$ auquel s'ajoute le bruit basse fréquence $B_{BF}$ et le signal parasite fourni par l'échantillonneur-bloqueur 22. Le signal qui est mémorisé dans le condensateur 23b de l'échantillonneur-bloqueur 23 contient le bruit basse fréquence $B_{BF}$ auquel s'ajoute le signal parasite PAR 2 fourni par le circuit échantillonneur-bloqueur 23, le signal parasite PAR 1 ayant été éliminé par l'échantillonneur-bloqueur 23. Le circuit soustracteur 25 qui effectue la soustraction entre l'amplitude du signal qui est mémorisé dans le condensateur 22b et l'amplitude du signal qui est mémorisé dans le condensateur 23b fournit dans ces conditions un signal qui vérifie la relation

$$(S_u + B_{BF} + PAR\ 2) - (B_{BF} + PAR\ 2) = S_u$$

Le signal fourni par la sortie du circuit soustracteur 25 apparaît par conséquent débarrassé des composantes de bruit et des parasites transmis par les différents échantillonneurs-bloqueurs, et dans le cas où le signal traité est un signal vidéo, l'alignement du noir pour chaque échantillonnage du signal de luminance sera dans ces conditions bien réalisé.

## Revendications

1. Circuit d'échantillonnage et maintien, pour le double échantillonnage corrélé d'un signal, le signal étant fourni par un étage convertisseur charge/tension (15, 17) d'un dispositif à transfert de charge, ce circuit d'échantillonnage comprenant un premier circuit échantillonneur bloqueur (22), un deuxième circuit échantillonneur bloqueur (23) identique au premier circuit échantillonneur et un troisième circuit échantillonneur bloqueur (21), le premier et le deuxième circuit échantillonneur bloqueur (22, 23) étant respectivement couplés par leurs sorties à une première et une deuxième entrée d'un circuit soustracteur (25), le signal fourni par le dispositif à transfert de charge étant appliqué d'une part, directement aux entrées respectives des premier et troisième circuits échantillonneurs bloqueurs (22, 21) et d'autre part, à l'entrée du deuxième circuit échantillonneur bloqueur (23) au travers du troisième circuit échantillonneur bloqueur (21), caractérisé en ce que le signal est un signal vidéo ($V_s$) partagé en trois intervalles de temps juxtaposés pour transmettre respectivement un niveau de noir, un signal de luminance et une impulsion d'initialisation, et que le premier et le deuxième circuit échantillonneur bloqueur (22, 23) sont commandés simultanément pendant les intervalles de temps où le signal de luminance apparaît, le troisième circuit échantillonneur bloqueur (21) étant commandé pendant les intervalles de temps où le niveau de noir est présent, de façon à aligner correctement le niveau de noir pour chaque échantillon du signal de luminance.

2. Circuit selon la revendication 1, caractérisé en ce que le premier et le deuxième circuit échantillonneur-bloqueur comprennent un condensateur (12) chargé au travers d'un interrupteur de courant (11).

3. Circuit selon la revendication 2, caractérisé en ce que chaque interrupteur de courant est constitué par un transistor à effet de champ (11).

4. Circuit selon les revendications 2 et 3, caractérisé en ce que la tension développée aux bornes du condensateur est lue au travers d'un transistor à effet de champ (13) monté en adaptateur d'impédance.

## Claims

1. A sample and hold circuit for the double correlated sampling of a signal, the said signal being supplied by a charge/voltage converter stage (15 and 17) from a charge transfer device, said sample circuit comprising a first sampling and blocking circuit (22), a second sampling and blocking circuit (23) identical to the first sampling circuit and a third sampling and blocking circuit (21), the first and the second sampling and blocking circuits (22 and 23) being respectively coupled at their outputs with a first and a second input of a subtracting circuit (25), the signal supplied by the charge transfer device being applied on the one hand directly to the respective inputs of the first and of the third sampling and blocking circuits (22 and 21) and on the other hand to the input of the second sampling and blocking circuit (23) through the third sampling and blocking circuit (21), characterized in that the signal is a video signal (Vs) distributed in three adjoining intervals of time in order to respectively transmit a black level, a luminance signal and an initialization pulse, and in that the first and the second sampling and blocking circuits (22 and 23) are simultaneously driven during time intervals in which the luminance signal appears, the third sampling and blocking circuit (21) being driven during time intervals in which the black level is present in such a manner as to correctly align the black level for each sample of the luminance signal.

2. The circuit as claimed in claim 2, characterized in that the first and the second sampling and blocking circuits comprise a capacitor (12) charged through a current switch (11).

3. The circuit as claimed in claim 2, characterized in that each current switch is constituted by a field effect transistor (11).

4. The circuit as claimed in claims 2 and 3, characterized in that the voltage developed at the terminals of the capacitor is read through a field effect transistor (13) placed in an impedance modifying circuit.

**Patentansprüche**

1. Schaltung für die korrelierte Doppelabtastung und Bewahrung eines Signals, das von einer Ladungs/Spannungs-Wandlerstufe (15, 17) einer Ladungsübertragungsvorrichtung geliefert wird, wobei die Abtastschaltung eine erste Abtast/Halte-Schaltung (22), eine mit der ersten Abtastschaltung identische zweite Abtast/Halte- Schaltung (23) und eine dritte Abtast/Halte-Schaltung (21) aufweist, wobei die erste und die zweite Abtast/Halte-Schaltung (22, 23) mit ihren jeweiligen Ausgängen mit einem ersten bzw. einem zweiten Eingang einer Subtrahierschaltung (25) verbunden sind, wobei das von der Ladungsübertragungsvorrichtung gelieferte Signal einerseits direkt an die entsprechenden Eingänge der ersten und der dritten Abtast/Halte-Schaltung (22, 21) und andererseits über die dritte Abtast/Halte-Schaltung (21) an den Eingang der zweiten Abtast/Halte-Schaltung (23) angelegt wird, dadurch gekennzeichnet, daß das Signal ein Videosignal (VS) ist, das in drei nebeneinanderliegende Zeitintervalle aufgeteilt ist, um einen Schwarzpegel bzw. ein Leuchtdichtesignal bzw. einen Initialisierungsimpuls zu übertragen, und daß die erste und die zweite Abtast/Halte-Schaltung (22, 23) während der Zeitintervalle, in denen das Leuchtdichtesignal auftritt, gleichzeitig gesteuert werden, wobei die dritte Abtast/Halte-Schaltung (21) während den Zeitintervallen, in denen der Schwarzpegel vorliegt, gesteuert wird, derart, daß der Schwarzpegel für jede Abtastung des Leuchtdichtesignals korrekt ausgerichtet wird.

2. Schaltung gemäß Anspruch 1, dadurch gekennzeichnet, daß die erste und die zweite Abtast/Halte-Schaltung jeweils einen über einen Stromunterbrecher (11) geladenen Kondensator (12) umfassen.

3. Schaltung gemäß Anspruch 2, dadurch gekennzeichnet, daß jeder Stromunterbrecher durch einen Feldeffekttransistor (11) gebildet wird.

4. Schaltung gemäß den Ansprüchen 2 und 3, dadurch gekennzeichnet, daß die an den Anschlüssen des Kondensators anliegende Spannung über einen als Anpassungstransformator geschalteten Feldeffekttransistor (13) gelesen wird.

# FIG_1

# FIG_2

# FIG_3

FIG_4

FIG_5

FIG_6

# FIG_7